# EUROPEAN PATENT APPLICATION

(11) **EP 2 199 435 A1**
(43) Date of publication of application: **23.06.2010**
(21) Application number: 09014968.3
(22) Date of filing: 02.12.2009
(51) Int. Cl.: C30B 29/06, C30B 33/02

(54) **Annealed wafer and method for producing annealed wafer**

(30) Priority: 18.12.2008 JP 2008322874
(71) Applicant: Siltronic AG, 81737 München (DE)
(72) Inventor: Ishisaka, Kazunori, 743-0075 Hikari, Yamaguchi (JP); Fukuda, Masayuki, 743-0072 Hikari, Yamaguchi (JP); Nakai, Katsuhiko, 743-0071 Hikari, Yamaguchi (JP)
(74) Representative: Staudacher, Wolfgang

(57) **Abstract**

**Problem**

A method for producing an annealed wafer having enhanced gettering effects for Cu is provided.

**Solution**

A method for producing an annealed wafer, characterized in comprising heating a silicon substrate containing a nitrogen concentration of 5×10¹⁴ to 1×10¹⁶/cm³, a carbon concentration of 1×10¹⁵ to 5×10¹⁶/cm³, and an oxygen concentration of 6×10¹⁷ to 11×10¹⁷/cm³ at a temperature of 650 to 800 ºC for a time equal to or longer than 4 hours, and subjecting the heated substrate to argon annealing at a temperature of 1100 to 1250 ºC, wherein internal stacking fault density after annealing is equal to or higher than 5×10⁸/cm³.

## Description

### Technical field

The present invention relates to an annealed wafer and a method for producing an annealed wafer.

### Background art

A semiconductor substrate, in particular, a silicon single crystal wafer (hereinafter it may also be referred to simply as a substrate) has been used as a substrate for the production of a highly-integrated MOS device. Most of the silicon single crystal wafers is a substrate cut off from an ingot of silicon single crystal produced by the Czochralski (CZ) method.

In such a silicon single crystal wafer, oxygen entrained during production of the single crystal is present in a supersaturated state, which will deposit in a subsequent device process to form oxygen precipitates (a deposit of silicon oxide is commonly known as BMD: Bulk Micro Defect) inside the substrate. Generation of the oxygen precipitates in an activated region of the device has been known to be a deterioration factor of device characteristics, such as decrease in withstand voltage of a gate oxidized film, or increase in junction leak current, while the generation of the oxygen precipitates in a bulk other than the activated region of the device effectively acts as a gettering source to capture contamination of heavy metals entrained during the device process, and has effects to maintain cleanly the substrate surface, which is the device activated layer.

Intrinsic gettering (IG) uses such effects technically, and has been used to prevent deterioration of device characteristics caused by heavy metal contamination. Therefore, the silicon single crystal wafer has been required to generate moderate oxygen precipitates during the device process.

In response to these requirements, various approaches have been tried. For example, nitrogen dope has been carried out in growing silicon single crystal by CZ method, which is capable of producing an ingot of the silicon single crystal having growth of a grown-in fault suppressed as well as promoting oxygen deposition. And, by subjecting a mirrored wafer, obtained by slicing and polishing the silicon single crystal doped with nitrogen, to heat treatment with an argon gas, a hydrogen gas, and the like at a high temperature (1100 to 1350ºC) for a long time (hereafter called "annealing"), a silicon semiconductor substrate (hereafter called "annealed wafer"), which attained both surface layer integrity and increase in oxygen deposit nucleus density in a bulk, can be produced. It has been known that the annealed wafer of such an IG material (mainly composed of the oxygen precipitates) has gettering capability for heavy metal impurities entrained during a process.

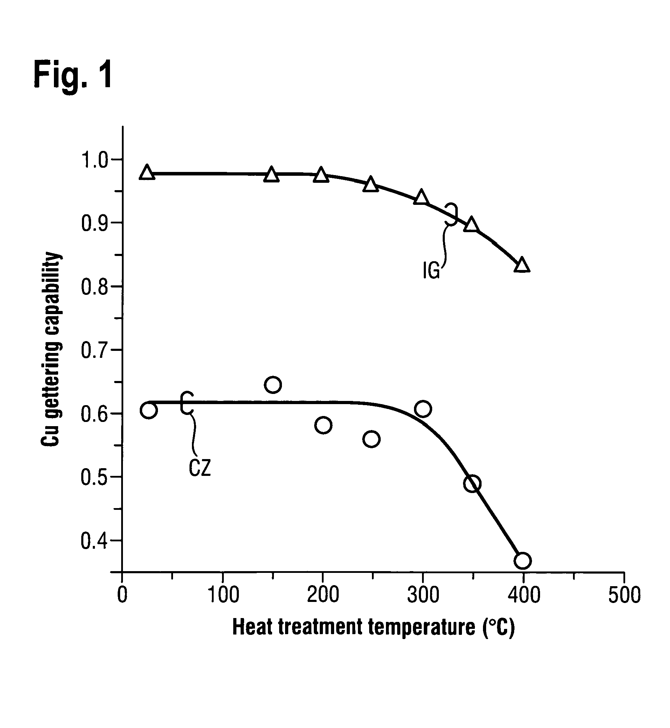

However, according to a report of Non-patent Literature 1, it has been pointed out as shown in Fig. 1 that even the IG material has weak gettering effects for Cu, a wiring material of a high rate device, and has a deterioration problem of device reliability caused by Cu contamination due to re-discharging of Cu gettered (captured) even by heat treatment in a device process at a low temperature (about 400ºC) like a wiring step. In addition, in a general DZ-IG wafer, 3-stage heat treatments have been carried out. IG effects have been obtained by subjecting a CZ substrate with high oxygen concentration to heat treatment at 3-stages, that is, at high temperature (about 1100ºC), at low temperature (about 650ºC) and at intermediate temperature (about 1000ºC). However, even in a wafer obtained by subjecting the general DZ-IG wafer to the 3-stage heat treatments, there is a problem of weak gettering effects for Cu, and thus deterioration of device reliability caused by Cu contamination due to re-discharging of Cu gettered (captured), even in heat treatment in a device process at a low temperature (about 400ºC) like a wiring step. [Non-patent Literature 1]: Kazuyuki Bokusawa, Jiro Yosigami, "Deterioration of device reliability caused by Cu contamination in a production process of a semiconductor, and its mechanism": A technological research report (Communication Institute Technology Report), SDM2002-188 (October, 2002), of The Institute of Electronics, Information and Communication Engineers, published by Aggregate Corporation, The Institute of Electronics, Information and Communication Engineers.

### Disclosure of the invention

### Problem to be solved by the invention

Under the above circumstances, it is an object of the present invention to provide an annealed wafer with enhanced gettering effects for Cu, and a method for producing the annealed wafer.

The present invention to attain the above object is an annealed wafer, **characterized in that** oxygen precipitates with a size of 10 nm to 120 nm are present in the number of equal to or more than 5×10¹¹/cm³, and stacking fault density is equal to or higher than 5×10⁸/cm³, at a position equal to or deeper than 50 µm from the surface of a silicon wafer.

A method for producing the annealed wafer of the present invention to attain the above object, is a method for producing an annealed wafer, characterized in comprising heating a silicon substrate containing a nitrogen concentration of 5×10¹⁴ to 1×10¹⁶/cm³, a carbon concentration of 1×10¹⁵ to 5×10¹⁶/cm³, and an oxygen concentration of 6×10¹⁷ to 11×10¹⁷/cm³ at a temperature of 650 to 800 ºC for a time equal to or longer than 4 hours, and subjecting the heated substrate to argon annealing at a temperature of 1100 to 1250 ºC, wherein internal stacking fault density after annealing is equal to or higher than 5×10⁸/cm³.

### Effects of the invention

According to the present invention, there can be provided an annealed wafer, which is capable of enhancing the gettering effects for Cu, suppressing re-discharging of gettered Cu even in heat treatment in a device process at a low temperature, preventing Cu contamination, and enhancing device reliability; and a method for producing the annealed wafer.

### Best mode for carrying out the invention

Explanation will be given below on best embodiments of the present invention, with reference to drawings accompanied.

### I. Method for producing annealed wafer

A method for producing an annealed wafer relevant to the present invention is characterized in comprising heating a silicon substrate containing a nitrogen concentration of 5×10¹⁴ to 1×10¹⁶/cm³, a carbon concentration of 1×10¹⁵ to 5×10¹⁶/cm³, and an oxygen concentration of 6×10¹⁷ to 11×10¹⁷/cm³ at a temperature of 650 to 800 ºC for a time equal to or longer than 4 hours (hereinafter referred to as "heat treatment step"), and (2) subjecting the heated substrate to argon annealing at a temperature of 1100 to 1250 ºC (hereinafter referred to as "annealing step"), wherein internal stacking fault density after annealing is equal to or higher than 5×10⁸/cm³, as well as the surface layer is free of faults. According to the production method, the stacking faults can be formed around a micro defect (BMD) composed of oxygen precipitates (nuclei) of IG material (mainly composed of the oxygen precipitates). Therefore, by making the stacking fault a gettering site for Cu, gettering effects for Cu, in particular, re-discharging suppression effects of Cu at a low temperature treatment (about 400 ºC) which has been at least gettered during cooling after high temperature treatment, can be enhanced. In addition, owing to gettering capability manifested by the oxygen precipitates (nuclei) of the IG material (mainly composed of the oxygen precipitates), excellent gettering capability for also impurities such as other heavy metals can be expressed sufficiently.

### Explanation will be given below by each of the constitutions.

### (1) Heat treatment step

### (a) Silicon substrate

A silicon substrate to be used in the heat treatment step may be prepared by adjusting a doping or contained concentration of nitrogen, carbon and oxygen, in growing silicon single crystal by CZ method. Among these, by nitrogen dope, a fault formed during crystal growth, what is called "void grown-in fault", can be made smaller, and by annealing with an argon gas carried out subsequently, not only surface void can be eliminated but also an ingot of silicon single crystal having oxygen deposition promoted, can be produced. And, the higher the nitrogen concentration is, the more oxygen deposit density increases.
This is because the addition of nitrogen forms oxygen deposit nuclei stable even at a high temperature in the silicon substrate, which remains without disappearing even after annealing at a high temperature (1100 to 125ºC). In an annealed wafer still having oxygen deposit nuclei remained in a silicon substrate, the oxygen precipitates is formed by heat treatment at the subsequent device step. The number of oxygen deposit nuclei stable even at a high temperature may depend on a nitrogen concentration. Therefore, increase in the nitrogen concentration may increases oxygen deposit density. In addition, by controlling a carbon dope or carbon amount, BMD in the present invention can be formed in the number exceeding 5×10¹¹/cm³. Still more, by controlling an oxygen dope or oxygen amount, BMD in the number exceeding 5×10¹¹/cm³ and with a size of 10 nm to 120 nm in the present invention can be formed. And, the mirrored wafer (silicon substrate) obtained by slicing and polishing a silicon single crystal doped with a suitable amount of nitrogen, carbon and oxygen, contains a nitrogen concentration of 5×10¹⁴ to 1×10¹⁶/cm³, a carbon concentration of 1×10¹⁵ to 5×10¹⁶/cm³, and an oxygen concentration of 6×10¹⁷ to 11×10¹⁷/cm³.

The nitrogen concentration of the silicon substrate is in the range of 5×10¹⁴ to 1×10¹⁶/cm³, and preferably 1×10¹⁵ to 5×10¹⁵/cm3. It can be said indispensable to set the nitrogen concentration within the above range in order to obtain an annealed wafer having excellent Cu gettering capability, with a density of oxygen deposit having a size of 10 nm to 120 nm in the range of not less than 5×10¹¹/cm³, and a stacking fault density of equal to or higher than 5×10⁸/cm³, by heat treatment of the subsequent device step. The nitrogen concentration below 5×10¹⁴/cm³ would provide a low nitrogen concentration, thus making the elimination of "grown-in fault" difficult. On the other hand, the nitrogen concentration over 1×10¹⁶/cm³ would make the growth of single crystal difficult.

In addition, the carbon concentration of the silicon substrate is in the range of 1×10¹⁵ to 5×10¹⁶/cm³, and preferably 2×10¹⁵ to 1×10¹⁶/cm³. The carbon concentration below 1×10¹⁵/cm³ would not attain sufficient BMD density. On the other hand, the carbon concentration over 5×10¹⁶/cm³ would generate a small number of low stacking faults.

In addition, the oxygen concentration of the silicon substrate is in the range of 6×10¹⁷ to 11×10¹⁷/cm³ (JEIDA) and preferably 7×10¹⁷ to 10×10¹⁷/cm³. The oxygen concentration below 6×10¹⁷/cm³ would provide a small BMD size and also low density of BMD. On the other hand, the oxygen concentration over 10×10¹⁷/cm³ BMD provide a too large BMD size.

A method for adjusting a dope or contained concentration of nitrogen, carbon and oxygen, in growing a silicon single crystal by CZ method like in the silicon substrate, is not especially limited. For example, the nitrogen addition can be attained by using a wafer having a silicon nitride film formed on a silicon substrate; and the carbon addition can be attained by immersing a carbon sheet into a molten silicon liquid. Oxygen can be adjusted by crystal pulling-up conditions such as a crucible-rotating rate. However, the present invention should not be limited to these methods, and by utilizing a conventionally known technology, as appropriate, dope or contained concentration of nitrogen, carbon and oxygen can be adjusted in growing a silicon single crystal.

The nitrogen concentration of the silicon substrate can be measured by SIMS (Secondary Ion Mass Spectrometry), while the carbon concentration and oxygen concentration can be measured by FT-IR (Fourier Transform Infrared Spectroscopy).

### (b) Heat treatment

In this step, the silicon substrate is subjected to heat treatment at a temperature of 650ºC to 800ºC for at least 4 hours. The heat treatment temperature below 650ºC would require a too long period of time for attaining a predetermined BMD density. On the other hand, the heat treatment temperature over 800ºC would not provide a sufficient BMD density.

In addition, the heat treatment time below 4 hours would provide a low BMD density. It should be noted that the upper limit of the heat treatment time is not especially limited, however, it is desirable to be equal to or shorter than 10 hours in view of cost.

In addition, atmosphere of the heat treatment is not especially limited. An atmosphere containing nitrogen and oxygen may be desirable in view of preventing nitriding of wafer surface.
Specifically, an atmosphere with an oxygen concentration of 0.1 to 1% by volume, and preferably 0.3 to 0.8% by volume, based on nitrogen gas may be preferably used.

However, as in a second heat treatment pattern to be described later, when heat treatment (heat treatment step) and annealing with an argon gas (annealing step) at a high temperature are continuously carried out, the heat treatment is also desirably carried out in an argon atmosphere. The annealing with an argon gas at a high temperature needs to be carried out in the absence of an oxidized film. Therefore, substitution of an atmosphere containing nitrogen and oxygen with an argon atmosphere in the midst of transition from the heat treatment step to the annealing step is not desirable, in terms of requiring removal of the oxidized film and the like, and making a continuous treatment difficult.
The heat treatment according to the present invention is enough to satisfy at least the above requirements. Explanation will be given below on a typical embodiment of heat treatment condition. It is natural that the present step should not be limited to these embodiments.

### (b1) First embodiment of heat treatment

The first embodiment of heat treatment comprises heat-treating a silicon substrate at a constant temperature T₁ within the range of 650ºC to 800ºC for at least 4 hours in an atmosphere containing nitrogen and oxygen (first embodiment). In this embodiment, a method for heating to the constant temperature T₁ is not especially limited. For example, it may comprise heating to the constant temperature T₁ at a predetermined temperature increasing rate, after inserting the silicon substrate into a furnace in an atmosphere containing nitrogen and oxygen; or comprise inserting the silicon substrate into a furnace heated at the constant temperature T₁ to rapidly increase the temperature thereof, which is not especially limited. In this embodiment, it is desirable that a temperature increasing rate to the constant temperature T₁ is made slower, and a holding time t₁ is made longer, in terms of growth of oxygen deposit nuclei. From these view points, the temperature increasing rate from a temperature at starting the temperature increase, that is, a temperature when the silicon substrate is inserted, to the constant temperature T₁ is 0.1 to 2ºC/minute, and preferably 0.3 to 1ºC/minute. The temperature increasing rate below 1ºC/minute would require an unduly long time till reaching the constant temperature T₁, which is uneconomical. On the other hand, the temperature increasing rate over 2ºC/minute would provide insufficient growth of oxygen deposit nuclei.

The constant temperature T₁ in this embodiment may be enough, as long as it is in the range of 650ºC to 800ºC.

In addition, in this embodiment, the heat treatment may be completed by pulling-up the silicon substrate outside a furnace, soon after holding it at the constant temperature T₁ for a predetermined time of at least 4 hours.

### (b2) Second embodiment of heat treatment

The second embodiment comprises continuously carrying out the heat treatment step and the annealing step. Specifically, it comprises heat-treating a silicon substrate at a constant temperature T₁ for predetermined time in an argon atmosphere as in the first embodiment, and thereafter subjecting the substrate to annealing step at a high temperature in an argon atmosphere in a furnace, without pulling-up the substrate outside the furnace, or without decreasing temperature. In the heat treatment according to this second embodiment, the heat treatment step and the annealing step may be carried out under argon atmosphere, as described above.

A above, typical embodiments of the heat treatment step, wherein the heat treatment is carried out at a temperature of 650ºC to 800ºC for equal to or longer than 4 hours have been described. However, the present invention should not be limited thereto. For example, heat treatments can be carried out in two or more stages; temperature may be increased or decreased arbitrarily, as long as it is in the range of 650ºC to 800ºC; or temperature increasing rate or decreasing rate in temperature increasing or decreasing may be determined arbitrarily. In addition, heat treatment time is also not especially limited, as long as it is equal to or longer than 4 hours in total. Further, the heat treatment may be carried out while continuously changing the temperature without maintaining at constant temperature.

### (2) Annealing step

After the heat treatment step as above, the annealing with argon is carried out at a temperature in the range of 1100ºC to 1250ºC. By carrying out the annealing with argon at a temperature in the range of 1100ºC to 1250ºC, not only oxygen deposit nuclei having a size to be eliminated by the heat treatment step at a high temperature can be grown sufficiently in advance to a size not to be eliminated, but also crystal faults in a surface layer can be eliminated.

In addition, as an atmosphere for the annealing with argon, an argon gas with an argon concentration of 100% by volume may be typically used. Also, a mixed atmosphere of argon gas with a hydrogen gas can be used. Usually, in preparation of an annealed wafer, the annealing at a high temperature can be carried out by using hydrogen gas and inert gas such as argon. In the present invention, the annealing with argon may be preferably selected to be carried out in the above atmosphere, in view of cost.

In the present step, in the case where the heat treatment step is carried out according to the first embodiment, an oxidized film may be etched from the surface of the silicon substrate which has been pulled up outside a furnace, and thereafter the substrate may be inserted into a furnace in an argon atmosphere. Alternatively, in the case where the heat treatment step is carried out according to the second embodiment, the silicon substrate which has been heat-treated in an argon atmosphere may be continuously placed in the furnace in an argon atmosphere, or transferred from the furnace for heat treatment in an argon atmosphere to a furnace for annealing treatment in an argon atmosphere (in this case, the silicon substrate under transferring outside the furnace is desirably maintained in an argon atmosphere) . The annealing with argon may be carried out at an annealing temperature T₂ in the range of 1100ºC to 1250ºC for an annealing time t₂ in the range of 5 minutes to 4 hours, and preferably at a temperature in the range of 1150ºC to 125ºC for 10 minutes to 4 hours. The annealing temperature T₂ below 1100ºC would not eliminate "grown-in fault" on the surface. The annealing temperature T₂ over 1250ºC would make a deposit of 1×10¹²/cm³ dissolved. The annealing time t₂ below 5 minutes would provide insufficient elimination of "grown-in fault", and the annealing time t₂ over 4 hours would reduce productivity.

### (a) Annealing

The annealing treatment according to the present invention may be carried out by holding the silicon substrate at a certain constant annealing temperature T₂ within the range of 1100ºC to 1250ºC for a predetermined time t₂ in an argon atmosphere. The temperature increasing rate to the above annealing temperature T₂ may be desirably 4 to 10ºC/minute at 650ºC to 1000ºC, and 0.4 to 6ºC/minute at 1000ºC to 1250ºC. Preferably, temperature increasing rate to the above annealing temperature T₂ may be 5 to 9ºC/minute at 650ºC to 1000ºC, and 0.5 to 5ºC/minute at 1000ºC to 1250ºC. The temperature increasing rate below 4ºC/minute at 650ºC to 1000ºC, or the temperature increasing rate below 0.4ºC/minute at 1000ºC to 1250ºC, would require an unduly long time to reach the above annealing temperature T₂, which is uneconomical. On the other hand, the temperature increasing rate over 10ºC /minute at 650ºC to 1000ºC, or the temperature increasing rate over 6ºC /minute at 1000ºC to 1250ºC would be insufficient for growth of the oxygen precipitates or stacking fault.

In the case where the heat treatment step is carried out according to the second embodiment, the silicon substrate which has been heat-treated in an argon atmosphere may be continuously heated to the annealing temperature T₂ at a predetermined temperature increasing rate in the furnace in an argon atmosphere.
Alternatively, the silicon substrate may be transferred from the furnace for heat treatment in an argon atmosphere to a furnace for annealing treatment heated to the annealing temperature T₂ in an argon atmosphere (in this case, the silicon substrate under transferring outside the furnace is desirably maintained in an argon atmosphere), and rapidly heated. It is not especially limited to them. Also in this embodiment, the temperature increasing rate to the above annealing temperature T₂ may be desirably selected to be 4 to 10ºC/minute at 650ºC to 1000ºC and 0.4 to 6ºC/minute at 1000ºC to 1250ºC, and annealing time t₂ may be desirably selected to be 10 minutes to 4 hours, in terms that concentration (density) of the oxygen precipitates with a size of 10 nm to 120 nm can be increased to a level equal to or more than 5×10¹¹/cm³, and stacking fault density can also be increased to a level equal to or higher than 5×108/cm³. From the above view points, it is desirable that the temperature increasing rate to the above annealing temperature T₂ is 5 to 9ºC/minute up to 1000ºC, and 0.5 to 5ºC/minute from 1000ºC to 1250ºC. The temperature increasing rate below 4ºC/minute from up to 1000ºC, or the temperature increasing rate below 0.4ºC/minute from 1000ºC to 1250ºC, would require a long time to reach the above annealing temperature T₂, which is uneconomical. On the other hand, the temperature increasing rate over 10ºC/minute up to 1000ºC, or the temperature increasing rate over 6ºC/minute from 1000ºC to 125ºC would be insufficient for growth of the oxygen precipitates or stacking fault.

In addition, in the annealing step according to the present invention, the annealing treatment may be completed by holding the silicon substrate (the annealed wafer) at the annealing temperature T₂ for the predetermined time t₂, cooling it down to a predetermined temperature T₃ at a temperature cooling rate of 1 to 5ºC/minute in the furnace in an argon atmosphere, and taking it out of the furnace.

In this case, the predetermined temperature T₃ may be in the range of 700 to 800ºC. The predetermined temperature T₃ below 700ºC would require a long time. On the other hand, the predetermined temperature T₃ over 800ºC may generate slip in some cases. In addition, the temperature decreasing rate below 1ºC/minute would require a long time, and the temperature decreasing rate of over 5ºC/minute may generate slip in some cases.

The above embodiment is a typical embodiment of the annealing step for carrying out the annealing with argon at a temperature of 1100ºC to 1250ºC. The present invention, however, should not be limited thereto. For example, temperature increase in arbitrary rate is possible, as long as it is within the range of the above temperature increasing rate at each temperature region, such as the temperature increasing rates up to annealing temperature T₂ may be selected at different values as in 3 or more stages.
Similarly, temperature increase or decrease rate in temperature increase or decrease may be determined arbitrarily, such as the temperature decreasing rate down to predetermined temperature T₃ may be selected at different values as in 2 or more stages. In addition, the annealing treatment with argon may be carried out by arbitrarily increasing or decreasing the annealing temperature T₂, as long as it is within a temperature range of 1100ºC to 1250ºC, and it may be changed constantly without maintaining at a constant temperature, and also in the arbitrary annealing time t₂, as long as in the range of 10 minutes to 4 hours, which is not especially limited.

### (3) Internal stacking fault density of annealed wafer

In the present invention, it is necessary that the internal stacking fault density is equal to or higher than 5×10⁸/cm³ in the annealed wafer subjected to annealing, and it is desirable that the internal stacking fault density is in the range of 1×10⁹ to 1×10¹⁰/cm³. The internal stacking fault density after the annealing below 5×10⁸/cm³ would provide weak gettering capability.

The internal stacking fault density after annealing was measured with an optical microscope by cleaving an annealed wafer subjected to annealing, and subjecting the cleaved surface to light etching.

### II. Annealed wafer

The silicon wafer (annealed wafer) relevant to the present invention is **characterized in that** oxygen precipitates with a size of 10 nm to 120 nm are present in the number of equal to or more than 5×10¹¹/cm³ in a layer from the surface of a silicon wafer to a position equal to or deeper than 50 µm therefrom, and stacking fault density is equal to or higher than 5×10⁸/cm³. By satisfying all of the above requirements, an annealed wafer can be provided which is capable of attaining an initial object of the present invention, enhancement of gettering effects to Cu, suppression of re-discharging of Cu gettered even in heat treatment in a device process at a low temperature, and enhancement of device reliability by preventing Cu contamination, in addition to characteristics as an existing IG material. Therefore, it can be utilized suitably to high density, highly integrated devices such as highly-integrated MOS devices.

### (Oxygen precipitates)

The silicon wafer (annealed wafer) of the present invention has oxygen precipitates with a size of 10 nm to 120 nm in the number of equal to or more than 5×10¹¹/cm³, and preferably 1×10¹² to 1×10¹³/cm³, in a layer from the surface of a silicon wafer to a position equal to or deeper than 50 µm therefrom. The oxygen precipitates with the above size in the number below 5×10¹¹/cm³ would provide weak slip resistance such as RTA (Rapid-Thermal-Annealing). It should be noted that the upper limit of the density of oxygen precipitates is not especially limited. It is desirable to be equal to or lower than 1×10¹³/cm³, because heat treatment at a low temperature for a long time would be required to increase the density.

A position equal to or deeper than 50 µm from the surface of a silicon wafer shall indicate specifically a range from 50 µm to the center. In the present invention, reason for excluding a range of a surface layer down to less than 50 µm from the surface of the silicon wafer is that the oxygen precipitates or stacking fault density generating inside the wafer, which is sufficiently apart from the device activated region at the vicinity of the wafer surface, has gettering effects by contamination of a heavy metal. Therefore, in the present invention, the oxygen precipitates and stacking fault density at the position equal to or deeper than 50 µm from the surface of a silicon wafer, excluding the relevant range, are specified herein.

In addition, reason for specifying a range of 10 nm to 120 nm as a size of the oxygen precipitates is that, although the oxygen precipitates with a size of below 10 nm may be included in a large quantity in the annealed wafer of the present invention, it is necessary for the size of oxygen precipitates to be over 10 nm to measure the deposit density with a transmission electron microscope (TEM) (= those with the size of below 10 nm cannot be measured by a TEM method), therefore the relevant range is excluded. On the other hand, although the oxygen precipitates having the size of over 120 nm can be included in the annealed wafer of the present invention, one having the size of over 120 nm would provide small fault density, therefore the relevant range is also excluded.

The oxygen precipitates can be determined by observing oxygen precipitates inside the silicon wafer with a transmission electron microscope, and counting oxygen precipitates with a size of 10 nm to 120 nm, at a position equal to or deeper than 50 µm from the surface of a silicon wafer. It should be noted that, as used herein, "size of oxygen precipitates" is defined as length of a diagonal line of octahedral oxygen deposit to be observed with a transmission electron microscope.

### (Stacking fault density)

In the annealed wafer of the present invention, the stacking fault density is equal to or higher than 5×10⁸/cm³, at a position equal to or deeper than 50 µm from the surface of a silicon wafer, and preferably 1×10⁹ to 1×10¹⁰/cm³. The above stacking fault density below 5×10⁸/cm³ would provide weak gettering capability. It should be noted that the upper limit of the stacking fault density is not especially limited.
The stacking fault density of the annealed wafer of the present invention can be measured with an optical microscope by cleaving a silicon wafer, and subjecting the cross-sectional surface to light etching for 2 minutes.
The annealed wafer of the present invention can be produced by the above method for producing the annealed wafer relevant to the present invention.

### Examples

### Example 1

By using CZ method, a silicon single crystal containing a nitrogen concentration of 3×10¹⁵/cm³ (measured with SIMS), a carbon concentration of 8×10¹⁵/cm³, and an oxygen concentration of 9×10¹⁷/cm³ (measured with FT-IR according JEIDA standard) was pulled-up.

After slicing and polishing the resulting silicon single crystal to obtained a mirrored wafer (a silicon substrate), inserting the mirrored wafer into a furnace in an atmosphere containing nitrogen and oxygen, specifically, an atmosphere containing oxygen in a concentration of 0.2% by volume, based on nitrogen gas, at 700ºC, during a fabrication process, the mirrored wafer was subjected to heat treatment at 700ºC for 4 hours, and then pulled-up from the furnace.

After that, an oxidized film of the silicon substrate under heat treatment was removed by etching, the silicon substrate was inserted in a furnace in an argon atmosphere, specifically, 100% of argon gas. After it was heated at a temperature increasing rate of 8ºC/minute from 700ºC to 1000ºC, 4ºC/minute from 1000ºC to 1100ºC, and 1ºC/minute from 1100ºC to 1200ºC, annealing with argon was carried out at 1200ºC for 1 hour, to pull up the silicon substrate from the furnace.

The inside oxygen precipitates after the annealing were observed with a transmission electron microscope, to find that oxygen precipitates with a size of 10 nm to 120 nm were present in an amount of 1×10¹²/cm³, at a position equal to or deeper than 50 µm from the surface of the silicon wafer. In addition, the annealed wafer after annealing was cleaved and subjected to light etching for 2 minutes, to observe an area of a depth of 50 µm from the surface in a cross-sectional structure with an optical microscope. As a result, stacking fault density was found to be 5×10⁸/cm³.

Fig. 2 is a drawing (photograph) showing a state by observing a cross-section of the annealed wafer obtained in Example 1, at a position of a depth of 100 µm from the surface. In the drawing, the oxygen precipitates are depicted as a small pit, and the stacking fault is depicted as a linear fault.

### Example 2

By using CZ method, a silicon single crystal containing a nitrogen concentration of 2×10¹⁵/cm³ (measured with SIMS), a carbon concentration of 8×10¹⁵/cm³, and an oxygen concentration of 9×10¹⁷/cm³ (measured with FT-IR according JEIDA standard) was pulled-up.

After slicing and polishing the resulting silicon single crystal to obtained a mirrored wafer (a silicon substrate), inserting the mirrored wafer into a furnace in an argon atmosphere, with an argon gas concentration of 100%, at 700ºC, during a fabrication process, the mirrored wafer was held in the furnace for 4 hours. Then, it was subjected to annealing with argon at 1200ºC for 1 hour, by increasing temperature at a temperature increasing rate of 8ºC/minute up to 1000ºC, and subsequently after the temperature increase, by increasing temperature at a temperature increasing rate of 4ºC/minute up to 1100ºC and 1ºC/minute up to 1200ºC, to pull up the silicon substrate from the furnace.

The inside oxygen precipitates after the annealing were observed with a transmission electron microscope, to find that oxygen precipitates with a size of 10 nm to 120 nm were present in an amount of 1×10¹²/cm³, at a position equal to or deeper than 50 µm from the surface of the annealed wafer (silicon wafer). In addition, the annealed wafer after annealing was cleaved and subjected to light etching for 2 minutes, to observe an area of a depth of 50 µm from the surface in a cross-sectional structure with an optical microscope. As a result, stacking fault density was found to be 1×10⁹/cm³.

### Comparative Example 1

A silicon single crystal containing a nitrogen concentration of 1×10¹⁵ to 5×10¹⁵/cm³ (measured with SIMS), and an oxygen concentration of 7×10¹⁷ to 10×10¹⁷/cm³ (measured with FT-IR according JEIDA standard), without the addition of carbon, was pulled-up.

After inserting a mirror faced wafer (a silicon substrate), obtained by slicing and polishing the resulting silicon single crystal, into a furnace under argon atmosphere, specifically with an argon gas concentration of 100%, at an insertion temperature of 700ºC, it was subjected to annealing under argon at 1200ºC for 1 hour, by increasing temperature in a temperature increasing rate of 8ºC/minute up to 1000ºC, 4ºC/minute up to 1100ºC and 1ºC/minute up to 1200ºC, and then it was pulled-up from the furnace.

After slicing and polishing the resulting silicon single crystal to obtained a mirrored wafer (a silicon substrate), inserting the mirrored wafer into a furnace in an argon atmosphere, with an argon gas concentration of 100%, at an insertion temperature of 700ºC, the mirrored wafer was subjected to annealing with argon at 1200ºC for 1 hour, by increasing temperature at a temperature increasing rate of 8ºC/minute up to 1000ºC, and subsequently after the temperature increase, by increasing temperature in a temperature increasing rate of 8ºC/minute up to 1000ºC, 4ºC/minute up to 1100ºC and 1ºC/minute up to 1200ºC, to pull up the silicon substrate from the furnace.

The inside oxygen precipitates after the annealing were observed with a transmission electron microscope, to find that oxygen precipitates with a size of 10 nm to 120 nm were present in an amount of 1×10⁹/cm³, at a position equal to or deeper than 50 µm from the surface of the annealed wafer (silicon wafer). In addition, the annealed wafer after annealing was cleaved and subjected to light etching for 2 minutes, to observe an area of a depth of 50 µm from the surface in a cross-sectional structure with an optical microscope. As a result, stacking fault density was found to be 1×10⁷/cm³.

### A method for evaluation of gettering

Cu contamination onto a wafer was carried out intentionally to evaluate gettering effects.

### (Wafer contamination)

The silicon wafers (annealed wafers) obtained in Examples 1 to 2 and Comparative Example 1, were washed with ammonia-hydrogen peroxide water (APM) + a diluted HF aqueous solution (DHF) + hydrochloric acid-hydrogen peroxide water (HPM), to impart hydrophilicity to the surface thereof. Then, by using a spin coating method, the wafer surface was contaminated with Cu. The amount of Cu contaminated on the surface, determined by atomic absorption analysis, was found to be 4×10¹²/cm². For the treatment to diffuse the surface Cu inside the wafer, diffusion was carried out at 950ºC for 5 minutes in a nitrogen atmosphere. Cu was once gettered during cooling down to room temperature after the diffusion. The heat treatment was subsequently carried out at 400ºC for 2 hours in a nitrogen atmosphere to carry out re-discharging treatment from the gettering site. Contamination amount was examined by atomic absorption analysis to determine an amount of Cu discharging to the surface. The amounts of Cu detected at the surface are shown in the following Table 1.

**Table 1**

| | Oxygen precipitates with size of 10 to 120 nm (/cm³) | Stacking fault density (/cm³) | Cu amount detected at the surface (/cm³) |
|---|---|---|---|
| Example 1 | 1×10¹² | 5×10⁸ | 5×10¹⁰ |
| Example 2 | 1×10¹² | 1×10⁹ | 4×10¹⁰ |
| Comparative Example 1 | 1×10⁹ | 1×10⁷ | 4×10¹¹ |

It was observed that Examples 1 and 2 showed a smaller amount of Cu detected at the surface, and higher gettering capability, in particular, re-discharging suppression effect from the relevant gettering site for Cu once gettered, as compared with Comparative Example 1.

### Brief description of the drawings

Fig. 1 is a drawing showing relation between Cu gettering capability and heat treatment temperature, in the case where a low temperature heat treatment in air atmosphere was added after a heat treatment at 950ºC for 5 minutes in nitrogen atmosphere, on a wafer obtained by using IG material and CZ method, excerpted from data reported in Non-Patent Literature 1.

Fig. 2 is a drawing showing a state by observing a cross-section of the annealed wafer with an optical microscope, which wafer was obtained by cleaving the annealed wafer (silicon wafer) obtained in Example 1 and subjected the cleaved wafer to light etching for 2 minutes to a position of a depth of 100 µm from the surface.

## Claims

1. An annealed wafer **characterized in that** oxygen precipitates with a size of 10 nm to 120 nm are present in the number of equal to or more than 5×10¹¹/cm³, and stacking fault density is equal to or higher than 5×10⁸/cm³, at a position equal to or deeper than 50 µm from the surface of a silicon wafer.

2. A method for producing an annealed wafer, **characterized in** comprising heating a silicon substrate containing a nitrogen concentration of 5×10¹⁴ to 1×10¹⁶/cm³, a carbon concentration of 1×10¹⁵ to 5×10¹⁶/cm³, and an oxygen concentration of 6×10¹⁷ to 11×10¹⁷/cm³ at a temperature of 650 to 800 ºC for a time equal to or longer than 4 hours, and subjecting the heated substrate to argon annealing at a temperature of 1100 to 1250 ºC,
wherein internal stacking fault density after annealing is equal to or higher than 5×10⁸/cm³.
